# EUROPÄISCHE PATENTSCHRIFT

(11) **EP 1 618 227 B1**
(45) Veröffentlichungstag und Bekanntmachung des Hinweises auf die Patenterteilung: **13.07.2011**
(21) Anmeldenummer: 04722239.3
(22) Anmeldetag: 22.03.2004
(51) Int. Cl.: C23C 16/44, C23C 16/452, C23C 16/30, C30B 25/14, C30B 29/40

(54) **VERFAHREN UND VORRICHTUNG ZUM ABSCHEIDEN VON HALBLEITERSCHICHTEN MIT ZWEI PROZESSGASEN, VON DENEN DAS EINE VORKONDITIONIERT IST**
METHOD AND DEVICE FOR DEPOSITING SEMICONDUCTOR LAYERS USING TWO PROCESS GASES, OF WHICH ONE IS PRECONDITIONED
PROCEDE ET DISPOSITIF POUR DEPOSER DES COUCHES SEMI-CONDUCTRICES AU MOYEN DE DEUX GAZ DE PROCEDE DONT UN EST PRECONDITIONNE

(30) Priorität: 30.04.2003 DE 10320597
(43) Veröffentlichungstag der Anmeldung: 25.01.2006
(73) Patentinhaber: Aixtron SE, 52134 Herzogenrath (DE)
(72) Erfinder: STRAUCH, Gerd, 52072 Aachen (DE); KÄPPELER, Johannes, 52146 Würselen (DE); REINHOLD, Markus, 40721 Hilden (DE); SCHULTE, Bernd, 52066 Aachen (DE)
(74) Vertreter: Grundmann, Dirk
(86) Internationale Anmeldenummer: PCT/EP2004/002994
(87) Internationale Veröffentlichungsnummer: WO 2004/097066

(56) Entgegenhaltungen:
- WO-A-01/46498
- US-A- 3 672 948
- DUPUIE J L ET AL: "THE LOW TEMPERATURE CATALYZED CHEMICAL VAPOR DEPOSITION AND CHARACTERIZATION OF ALUMINUM NITRIDE THIN FILMS" JOURNAL OF VACUUM SCIENCE AND TECHNOLOGY: PART A, AMERICAN INSTITUTE OF PHYSICS. NEW YORK, US, Bd. 10, Nr. 1, 1992, Seiten 18-28, XP000261639 ISSN: 0734-2101

## Beschreibung

Die Erfindung betrifft ein Verfahren zum Abscheiden mindestens einer Schicht, insbesondere Halbleiterschicht auf mindestens einem in einer Prozesskammer eines Reaktors von einem Substrathalter getragenen Substrat, wobei die Schicht aus mindestens zwei in einem kontrollierten (fest oder variierendem) stöchiometrischen Verhältnis stehenden Materialkomponenten besteht, die jeweils in Form eines ersten und eines zweiten Reaktionsgases in den Reaktor eingeleitet werden, wo die Reaktionsgase zufolge einer Energiezufuhr chemisch zerlegt werden und ein Teil der Zerlegungsprodukte die Schicht bildet, wobei das Angebot des ersten, eine niedrige thermische Aktivierungsenergie aufweisenden Reaktionsgases die Wachstumsrate der Schicht bestimmt und das zweite, eine hohe thermische Aktivierungsenergie aufweisende Reaktionsgas im Überschuss angeboten und insbesondere durch ergänzende Energiezufuhr vorkonditioniert wird, wobei das erste Reaktionsgas durch eine Vielzahl von Öffnungen, die verteilt auf einer dem Substrathalter gegenüberliegenden Fläche eines Gaseinlassorganes angeordnet sind, in Richtung auf den Substrathalter strömt.

Die Erfindung betrifft darüber hinaus eine Vorrichtung insbesondere zur Durchführung des Verfahrens mit einer in einem Reaktor angeordneten Prozesskammer, welche Prozesskammer einen Substrathalter für mindestens ein Substrat aufweist, mit einer Heizvorrichtung, um den Substrathalter auf eine Prozesstemperatur aufzuheizen, mit einem dem Substrathalter gegenüberliegenden Gaseinlassorgan zum Einleiten eines ersten Reaktionsgases in die Prozesskammer, wobei das Gaseinlassorgan eine Vielzahl von Öffnungen zum Austritt des ersten Reaktionsgases aufweist, welche Öffnungen verteilt auf der dem Substrathalter gegenüberliegenden Fläche des Gaseinlassorganes angeordnet sind, und mit einer Vorrichtung zur Vorkonditionierung eines zweiten, in die Prozesskammer einzuleitenden Prozessgases.

Zur Herstellung von Leuchtdioden, insbesondere grünen, blauen und auch weißem Leuchtdioden werden CVD-Systeme und insbesondere MOCVD-Systeme verwendet. Zur Abscheidung weißer Leuchtdioden werden Verbindungsnitride auf einer Halbleiteroberfläche abgeschieden. Bei den bisherigen Fertigungsverfahren werden erste und zweite Prozessgase beispielsweise in Form von TMG oder NH₃ in die Prozesskammer gebracht, wo die Prozessgase zerfallen bzw. miteinander reagieren und die Reaktions- bzw. Zerfallsprodukte schichtbildend sich auf der Oberfläche eines Substrates abscheiden. Die bislang verwendeten Verfahren sind kostenaufwändig, da der Materialaufwand insbesondere betreffend das Stickstoffhydrid erheblich höher ist als der Materialaufwand für das Metallalkyl, beispielsweise TMG. NH₃, PH₃ oder ASH₃ müssen in einer um Größenordnung höheren Konzentration in die Prozesskammer eingebracht werden als die Metallalkyle. Obwohl die Hydride vergleichsweise preiswert gegenüber den Alkylen sind, sind die Verbrauchskosten aufgrund des hohen Verbrauchs etwa gleich hoch. Der hohe Verbrauch ist eine Folge der hohen thermischen Aktivierungsenergie der Hydride im Vergleich zu den Aktivierungsenergien der Metallalkyle.

Um eine Zerlegung der Reaktionsgase zu fördern, schlägt die US 4,539,068 vor, zwischen dem Gaseinlassorgan und dem Substrathalter ein Plasma zu zünden.

Auch die US 3,757,733 schlägt zu diesem Zwecke ein Plasma in der Prozesskammer vor.

Die US 6,289,842 B1 befasst sich mit dem Abscheiden von Halbleiterschichten im-MOCVD-System, wobei die Prozessgase durch einen showerhead in die Prozesskammer eingeleitet werden.

Eine Plasmavorbehandlung eines Reaktionsgases ist auch aus der JP 08-167596 bekannt

Die Einbringung der Alkyle getrennt von den Hydriden beschreibt die WO 01/46498.

Ausgehend von der eingangs geschilderten Situation, dass die mit den bekannten Verfahren gefertigten Leuchtdioden aus Kostengründen keine große Verbreitung finden, liegt der Erfindung die Aufgabe zugrunde, Maßnahmen anzugeben, mit welchen sich das Lumen/Kosten-Verhältnis in erheblichem Maße steigern läßt.

Die Lichtausbeute in Bezug auf die eingesetzten Herstellungskosten wird erfindungsgemäß dadurch verbessert, dass nur das zweite Prozessgas, welches getrennt vom ersten Prozessgas in die Prozesskammer eingeleitet wird, vor dem Eintritt in die Prozesskammer vorkonditioniert wird. Die Zerlegungsprodukte treten am Rande des Substrathalters unmittelbar oberhalb desselben in die Prozesskammer ein und diffundieren innerhalb der Diffusionsgrenzschicht parallel zur Substrathalteroberfläche. Die zur Durchführung dieses Verfahrens erfindungsgemäß vorgeschlagene Vorrichtung zeichnet sich dadurch aus, dass zur Vorkonditionierung am Rande des Substrathalters eine Vorkonditionierungsvorrichtung angeordnet ist. Der Substrathalter hat vorzugsweise eine Ringform, wobei sich der Ring um sein Zentrum drehen kann. Im Zentrum dieses Rings (am Ringinnenrand) befindet sich dann die Vorkonditionierungsvorrichtung. Es ist aber auch vorgesehen, dass die Prozesskammer eine lineare Form oder eine Trichterform besitzt Dann weist der Substrathalter vorzugsweise eine Rechteckform bzw. eine Trapezform auf. Vor der Suszeptors befindet sich dann die Vorkonditionierungseinrichtung. Das erste Prozessgas (Metallalkyle), bei dem es sich vorzugsweise um Trimethylgallium handelt, wird durch eine Vielzahl von Öffnungen in die Prozesskammer eingeleitet. Dabei befinden sich die Öffnungen in der Wandung, die dem Substrathalter unmittelbar gegenüberliegt. Die Einströmrichtung des Gases erstreckt sich quer zur Oberfläche des Substrathalters. Die Gasabströmrichtung erstreckt sich quer zur Gaseinström richtung parallel zur Substratoberfläche, also parallel zur Wandung. Diese Wandung bildet ein duschkopfartig ausgebildetes Gaseinlassorgan aus. Der Gasabströmrichtung, die parallel zur Oberfläche des Substrathalters gerichtet ist, vor- bzw. nachgeordnet dem Gaseinlassorgan sind in der Decke der Prozesskammer weitere Öffnungen angeordnet, durch die ein Trägergas, beispielsweise Wasserstoff oder Stickstoff in die Prozesskammer einströmt. Der Strom dieses Trägergases ist auf den Strom des durch die Öffnungen des Gaseinlassorganes einströmenden Trägergases derart abgestimmt, dass sich eine möglichst flache Diffusions-/Strömungsgrenzschicht oberhalb des Substrathalters ausbildet Dabei liegt die Strömungs-/Diffusionsgrenzschicht möglichst in der unteren Hälfte der Prozesskammer. Das vorkonditionierte zweite Prozessgas wird in Form von Radikalen innerhalb dieser Diffusions-/Strömungsgrenzschicht in die Prozesskammer injiziert. Zur Herstellung der Radikalen besitzt die Vorkonditionierungsvorrichtung vorzugsweise einen Plasmagenerator oder eine Heißdrahtvorrichtung oder katalytischer Einrichtung oder Kombination aus Vorstehendem. Mit letzterer wird das zweite Prozessgas auf solche Temperaturen gebracht, dass es sich in hohem Grade zerlegt.

Die Öffnungen des Gaseinlassorganes für das erste Prozessgas liegen so dicht beieinander, dass die aus den Öffnungen heraustretenden Gas-Jets nicht als Einzelgas-Jets den Substrathalter treffen, sondern das quer zur Richtung dieser Gas-Jets eintretende zweite Reaktionsgas flach gegen den Substrathalter drükken. Hierdurch kann der Materialeinsatz für das zweite Reaktionsgas in erheblichem Maße reduziert werden. Während das Konzentrationsprofil des ersten Prozessgases mit der niedrigen thermischen Aktivierungsenergie im Wesentlichen flach und gleichbleibend über die gesamte Länge des Substrathalters verläuft, nimmt das Konzentrationsprofil der Radikalen in Richtung der Hauptgasstromrichtung ab. Dabei ist aber sichergestellt, dass die Konzentration der Radikalen immer größer ist als die Konzentration des ersten Prozessgases unmittelbar oberhalb des Substrates. Zufolge dieser Einstellung sind die Zerlegungsprodukte des zweiten Prozessgases immer im Überschuss vorhanden. Die Wachstumsrate wird durch das Angebot des ersten Prozessgases bestimmt. Das Überangebot des zerlegten zweiten Prozessgases hat zur Folge, dass die abgeschiedene Schicht eine geringe Anzahl von Fehlstellen EPD besitzt. Die Fehlstellenkonzentration liegt vorzugsweise unterhalb von 10¹¹ cm⁻². Wegen dieser geringen Tendenz, Fehlstellen einzubauen, können Wachstumsraten erzielt werden, die höher liegen als die des Standes der Technik und insbesondere auch höher liegen als 5µm/h. Erfindungsgemäß kann das zweite Reaktionsgas ein Hydrid sein. Insbesondere Arsin, Phosphin, Ammoniak oder UDMH kommt in Frage. Diese Gase lassen sich thermisch und/ oder katalytisch in der Vorkonditionierungsvorrichtung nahezu vollständig in Radikale zerlegen. Deshalb braucht der Massengasfluss des in die Vorkonditioruerungsvorrichtung eingeleiteten zweiten Reaktionsgases nur geringfügig größer sein als der Massenfluss des in das Gaseinlassorgan eingeleiteten ersten Prozessgases. Typischerweise liegt der Massengasfluss des ersten Prozessgases, beispielsweise TMG, bei wenigen, bspw. 3 sccm. Der Massengasfluss des in die Vorkonditionierungseinrichtung eingeleiteten Hydrides ist nur etwa drei mal so groß. Zusätzlich kann in das Gaseinlassorgan noch ein erheblich größerer Massenfluss eines Trägergases eingeleitet werden. Der Massenfluss des hierzu verwendeten Stickstoffs oder Wasserstoffs kann etwa 30 slm betragen. Wegen der nahezu vollständigen Zerlegung des zweiten Prozessgases innerhalb der Vorkonditionierungsvorrichtung ist trotzdem das Angebot der Zerlegungsprodukte des zweiten Prozessgases in der Gasphase unmittelbar oberhalb der SubstratoberFläche größer als das Angebot des zerlegten oder nicht zerlegten ersten Prozessgases, bei dem es sich neben TMG auch um TMI bzw. andere Metallalkyle handeln kann. Die Prozesstemperaturen können in weitem Rahmen variiert werden. Sie können zwischen 400°C und 1600°C liegen. Die Beeinträchtigung des Temperaturprofils innerhalb der Prozesskammer durch ein thermisch vorkonditioniertes zweites Reaktionsgas ist wegen des verhältnismäßig geringen Massenflusses und Wärmekapazität vernachlässigbar. Wesentlich ist, dass die Diffusion der vorkonditionierten Hydride quergerichtet ist zu der aus einem CCS-showerhead austretenden Alkyl-Gasstromes. Das zusammen mit dem Alkylgas aus dem showerhead austretende Trägergas staucht die Strömung der vorkonditionierten Hydride hydrodynamisch an die Kristallzuchtoberfläche. Die hohe Stoffmenge des Trägergasstromes durch die Einspeisung über das Gaseinlassorgan führt zu einer derart hohen Verdünnung der Hydride am Ort der Oberfläche des Gaseinlassorganes, dass das Reaktionsgleichgewicht zur Bildung parasitärer Belegungen am Gaseinlassorgan deutlich < 1 ist. Dies hat zur Folge, dass die Prozesskammer in größeren Intervallen gereinigt werden muss als es beim Stand der Technik erforderlich ist. Zufolge des erfindungsgemäßen Vorschlages wird der Massenfluss des Hydrides gegenüber dem Stand der Technik um einen Faktor 100 reduziert. Gleichzeitig damit verringert sich die Defektdichte in den abgeschiedenen Schichten, so dass damit hergestellte im UV emittierende Leuchtdioden (GaN) mit einem höheren Strom, also einer höheren Lichtausbeute betrieben werden können.

Ausführungsbeispiele der erfindungsgemäßen Vorrichtung werden anhand beigefügter Zeichnungen nachfolgend erläutert. Es zeigen:
- Fig.1: in schernatischer Darstellung einen Tunnelreaktor mit trichterförmiger Prozesskammer;
- Fig. 2: den Reaktor nach Fig.1 in Draufsicht auf den Substrathalter;
- Fig. 3: einen alternativen Ringreaktor im Radialschnitt;
- Fig. 4: einen alternativen Ringreaktor im Querschnitt;
- Fig. 5: schematisch die Radikalenkonzentration unmittelbar oberhalb der Substratoberfläche in Richtung der Hauptgasflussrichtung;
- Fig. 6: eine alternative Reaktorform in der Darstellung gemäß Fig. 2;
- Fig. 7: eine alternative Reaktorform zum Reaktor gemäß Fig. 3;
- Fig. 8: eine weitere Alternative eines Reaktors und
- Fig. 9: eine weitere Alternative in einer grob schematischen Darstellung.

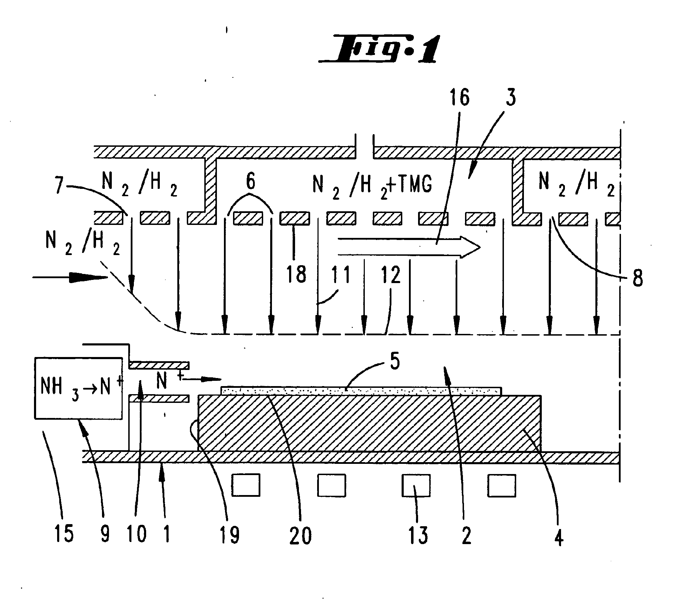

Der in der Figur 1 dargestellte Reaktor 1 besitzt ein nicht dargestelltes Gehäuse. Innerhalb des Gehäuses des Reaktors 1 befindet sich eine Heizeinrichtung 13, mit der ein Substrathalter 4 auf Prozesstemperatur geheizt werden kann. Auf dem Substrathalter 4 befindet sich ein Substrat, auf dem eine Schicht abgeschieden werden soll. Es ist auch möglich, dass sich auf dem Substrathalter 4 eine Vielzahl von Substraten 5 befindet.

Oberhalb des Substrathalters 4 befindet sich die Prozesskammer 2. Die Prozesskammer 2 wird nach oben hin durch ein Gaseinlassorgan 3 begrenzt. Dieses Gaseinlassorgan 3 bildet eine Gasaustrittsfläche 18 aus, die sich parallel zur Oberfläche 20 des Substrathalters 4 erstreckt. In der Gasaustrittsfläche 18 befinden sich in bekannter Weise Gaseintrittsöffnungen 6. Diese Gaseintrittsöffnungen 6 sind derart über die Gasaustrittsfläche 18 verteilt, dass die aus den Gaseintrittsöffnungen 6 austretenden und in die Prozesskammer in Gaseinströmrichtung eintretenden Gas-Jets in einen Bereich, der unterhalb der Mitte der Prozesskammerhöhe liegt, ein gleichmäßiges Gasströmungsfeld in Richtung auf den Substrathalter 4 ausbilden. Oberhalb der Strömungs/Diffusionsgrenzschicht 12 stellt sich aber eine Gasabströmung 16 ein, die quergerichtet ist zur Gaseinströmrichtung 11.

Stromaufwärts der Gaseintrittsöffnungen 6 befinden sich weitere Gaseintrittsöffnungen. Auch stromabwärts der Gaseintrittsöffnungen 6 befinden sich weitere Gaseintrittsöffnungen 8. Während durch die Öffnungen 6 des Gaseinlassorganes 3 nicht nur ein Trägergas in Form von N₂ oder H₂ treten kann, sondern insbesondere auch das erste Prozessgas in Form von TMG (TrimethylGallium) oder TMI (TrimethylIndium), treten durch die diesen Gaseintrittsöffnungen 6 benachbarten Gaseintrittsöffnungen 7, 8 nur die Trägergase Stickstoff oder Wasserstoff in die Prozesskammer ein, um die Strömungs/Diffusionsgrenzschicht 12 auch im Randbereich oberhalb des Substrathalters 4 parallel laufend zur Oberfläche 20 zu konditionieren.

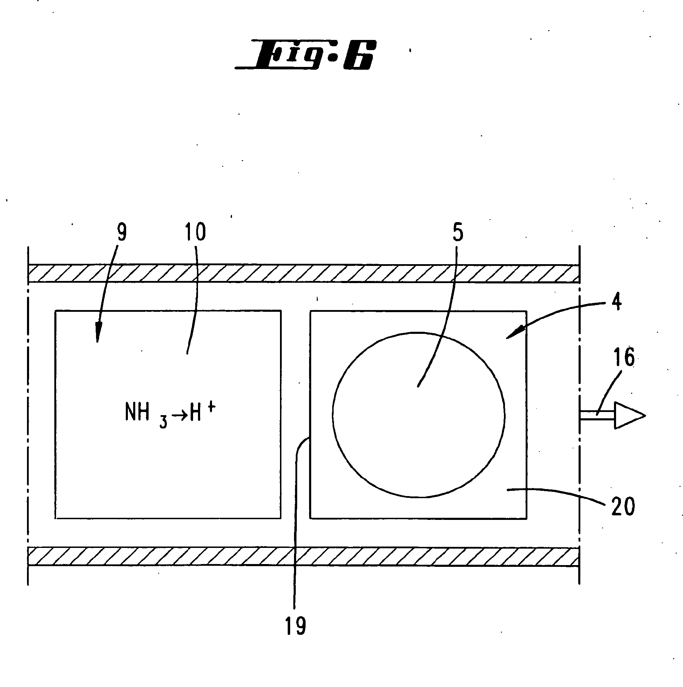

Bei dem in der Fig. 6 dargestellten Ausführungsbeispiel besitzt der Substathalter 4 in Draufsicht eine rechteckige Oberfläche. Die Prozesskammer weitet sich hier in Richtung der Gasabströmrichtung 16 aus. Die Prozesskammer hat über dem gesamten Substrathalter in Gasabströmrichtung 16 einen gleichbleibenden Querschnitt

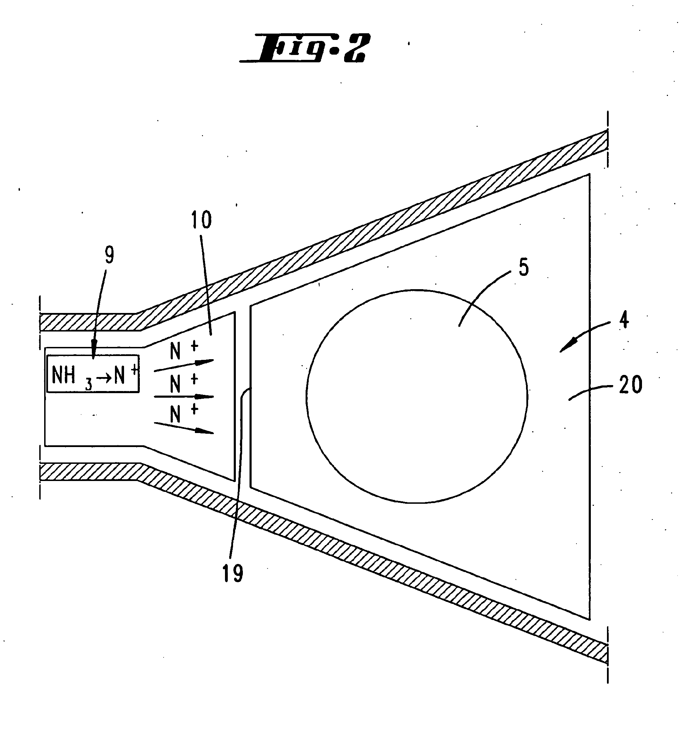

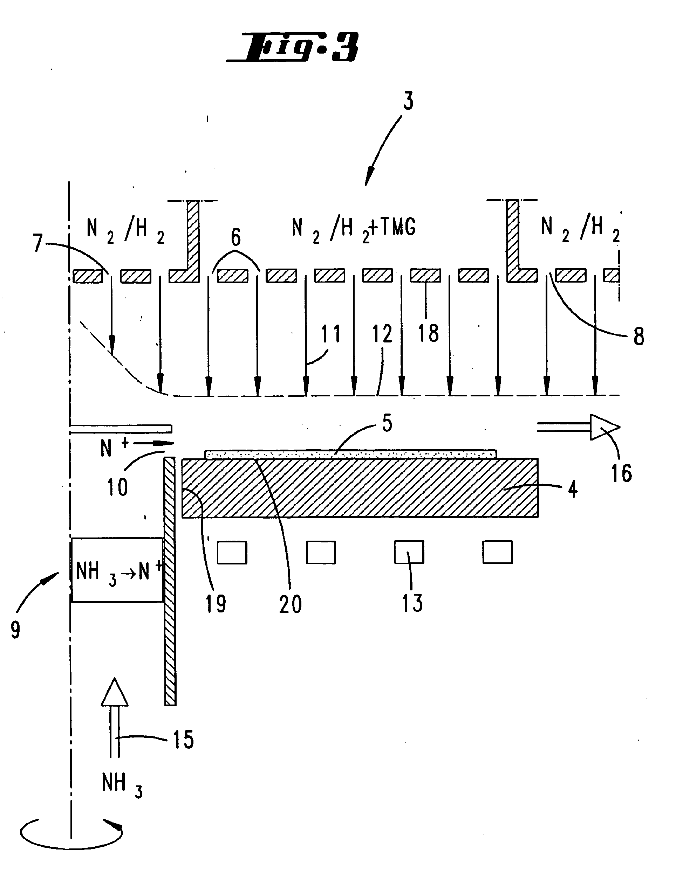

Die zuvor beschriebenen Eigenschaften besitzt auch der Reaktor, der in der Figur 3 dargestellt ist. Während der Substrathalter 4 des in den Fig.1 und 2 dargestellten Reaktors eine Trapezform ausbildet, besitzt der Substrathalter 4 des in der Fig. 3 dargestellten Reaktors eine Ringform. Auf diesen ringförmigen Substrathalter 4 befinden sich mehrere Substrate 5. Der Substrathalter 4 kann drehangetrieben werden. Die auf dem Substrathalter 4 aufliegenden Substrate können in bekannter Weise ebenfalls drehangetrieben sein. Die Beheizung des Substrathalters 4 erfolgt in bekannter Weise entweder über eine RF-Heizung oder durch Wärmestrahlung.

Wesentlich ist, dass durch das duschkopfartig ausgebildete Gaseinlassorgan 3 nur das Alkyl zusammen mit einem Trägergas in die Prozesskammer 2 einströmt. Das Hydrid, bei dem es sich um NH₃, PH₃ oder AsH₃ handeln kann, strömt über eine Hydridzuleitung 15 in eine Vorkonditionierungsvorrichtung 9. Bei dem in den Figuren 1 und 2 dargestellten Ausführungsbeispiel liegt die Vorkonditionierungsvorrichtung 9 in Hauptstromrichtung 16 vor einem Rand 19 des Substrathalters. Bei dem in der Fig. 3 dargestellten Ausführungsbeispiel liegt die dort nur hälftig dargestellte Vorkonditionierungsvorrichtung 9 im Zentrum des Ringinnenraumes des ringförmigen Substrathalters 4. Die Zuleitung 15 für das Hydrid kann dort von unten erfolgen.

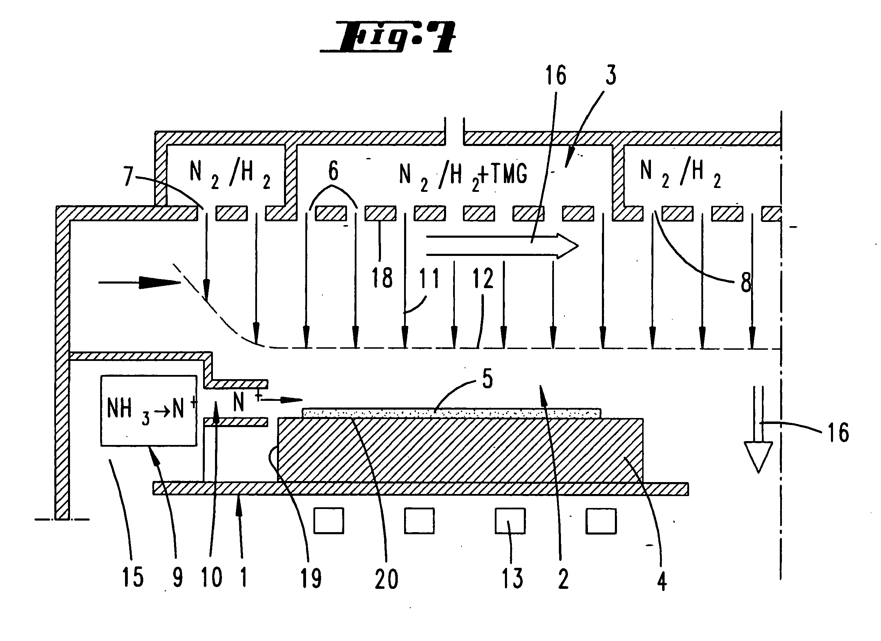

Bei dem in Fig. 7 dargestellten Ausführungsbeispiel ist der Substrathalter 4 ebenfalls ringförmig ausgestaltet.

Auch hier erfolgt die Injektion der von der Vorkonditionnierungseinrichtung 9 erzeugten Radikale vom Rande 19 des Substrathalters her. Anders als bei dem in Fig. 3 dargestellten Ausführungsbeispiel erfolgt die Injizierung aber vom Außenrand her, so dass sich eine kompressive Diffusion zur Substratoberfläche ausbildet. Das Verarmungsprofil wird dadurch kompensiert.

Die Vorkonditionierungsvorrichtung 9 ist in den grafischen Darstellungen nur symbolisch dargestellt. Es kann sich bei Vorkonditionierungsvorrichtung 9 um einen Plasmagenerator handeln. Bevorzugt handelt es sich bei der Vorkonditionierungsvorrichtung 9 aber um eine thermische Zerlegungseinrichtung des Hydrides. Es kann sich dabei um eine "Hot wire"-Einrichtung handeln. Mit dieser Einrichtung, die auf hohe Temperaturen aufgeheizte Drähte aufweist, wird das Hydrid in Radikale zerlegt. Die Zerlegung des Hydrides in Radikale erfolgt bevorzugt nahezu vollständig.

Die im Ausführungsbeispiel aus Ammoniak in der Vorkonditionierungsvorrichtung 9 hergestellten Stickstoffradikale N+ werden durch einen Austrittskanal 10 in die Prozesskammer 2 geleitet. Der Austrittskanal 10 bildet eine Injektionsöffnung und mündet unmittelbar oberhalb der Oberfläche 20 des Substrathalters 4 in die Prozesskammer und speziell dort in die Diffusionsgrenzschicht. Dabei befindet sich die Mündung des Austrittskanales 10 am Rande des Substrathalters 19. Hierdurch entsteht ein N+-Strom, der sich parallel zur Substratoberfläche 20 erstreckt und orthogonal zur Strömungsrichtung der Gas-Jets 11 (Einströmrichtung) gerichtet ist. Die Gas-Jets 11 drücken den Diffusionsstrom der Stickstoffradikale gegen die Oberfläche des Substrates 5.

Die Vorrichtung zur Aufnahme der Vorkonditionierungsvorrichtung 9 besitzt bei dem in Fig. 3 dargestellten Ausführungsbeispiel eine im Wesentlichen zylindrische Form, wobei der Zylinder ein abgedeckter Hohlkörper ist. Der Austrittskanal 10 ist bei dem in den Fig.1 und 2 dargestellten Ausführungsbeispiel trichterförmig gestaltet.

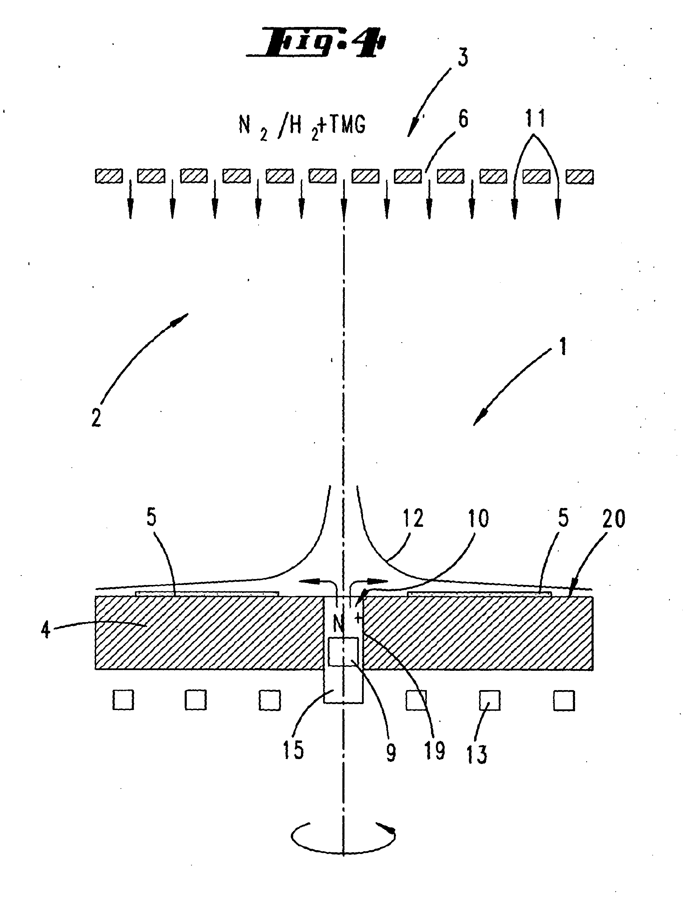

Der in Fig. 4 dargestellte alternative Reaktor 1 besitzt eine Prozesskammer 2, die erheblich höher ist als die Prozesskammern der Ausführungsbeispiele der Fig.1 bis 3. Dafür wird der dort ebenfalls ringförmige Substrathalter 4 mit einer höheren Drehzahl betrieben. Dies führt zu einem "Flachziehen" der Strömungs-/Diffusionsgrenzschicht 12 oberhalb der Substratoberfläche 5. Hier braucht die Vorrichtung zur Aufnahme der Vorkonditionierungsvorrichtung 9 keinen Dekkel besitzen. Je nach Prozessparameter ist es aber auch hier vorteilhaft, wenn ein Deckel vorhanden ist. Die aus der im Austrittskanal 10, der nach oben gerichtet ist, austretenden Radikale werden von der Strömung unmittelbar oberhalb des Austrittskanales 10 in Querrichtung zu den Gas-Jets 11 und parallel zur Oberfläche 20 des Substrathalters umgelenkt.

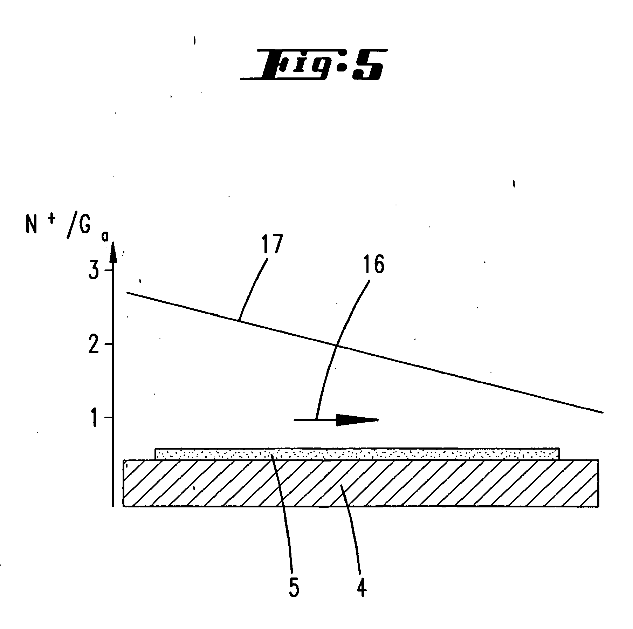

Die Fig. 5 zeigt den K6nzentrationsverlauf der aus dem Austrittskanal 10 austretenden Stickstoffradikale N+ im Verhältnis zur Galliumkonzentration in der Gasphase oberhalb der Substratoberfläche. Die Stickstoffradikale sind im Überschuss vorhanden, wobei sich die Konzentration 17 der Stickstoffradikale in Richtung des Hauptgasflusses 16 verringert. Das Verhältnis N,+/Ga bleibt aber über die gesamte Länge (Fig. 1 und 2) bzw. den gesamten Radius (Fig. 3 und 4) >1.

Bei typischen Prozesstemperaturen, die 400, 500, 600, 700, 800, 900,1000,1100, 1200,1300,1400,1500, -1600°C und jedem Zwischenwert und mehr betragen können, werden Massenflüsse von Trimethylgallium in die Prozesskammer 2 geleitet, die zwischen 2 und 10 sccm liegen. Der Massenfluss von NH₃, der durch die Leitung 15 in die Vorkonditionierungsvornchtung 9 eingebracht wird, ist nur geringfügig, insbesondere nur um einen Faktor 2 oder 3 größer als der TMG-Massenfluss: Demgegenüber ist der Massenfluss des durch die Öffnungen 6, 7, 8 eingeleiteten Trägergases (H₂, N₂) um den Faktor 1000 größer als der Massenfluss eines der beiden Reaktionsgase.

Die Erfindung kann auch mit mehr als zwei Reaktionsgasen verwirklicht werden. Es ist insbesondere vorgesehen, neben Trimethylgallium. auch Trimethylindium bzw. TMAL oder DcpMg in die Prozesskammer 2 einzuleiten. Ebenfalls können auch andere Alkyle dort eingeleitet werden. Desweiteren kann anstelle oder zusammen mit NH₃ PH₃ und/oder AsH₃ auch jedes andere Hydrid, wie UDMH in die Prozesskammer eingeleitet werden. Diese Hydride werden vorzugsweise auch in der oben beschriebenen Weise vorkonditioniert

Die Hydride können konzentriert oder mit einem Trägergas in die Vorkonditionierungsvorrichtung 9 eingebracht werden. Bevorzugt erfolgt die Einbringung der Hydride mit sehr wenig Trägergas, um eine Verdünnung des vorkonditionierten Gases zu minimieren. Die Temperatur in der Vorkonditionierungseinrichtung kann dabei höher oder niedriger sein als die Prozesstemperatur in der Prozesskammer.

In einer nicht dargestellten Variante der Erfindung ist es vorgesehen, dass die Substrathalter selbst drehangetrieben werden. Sie können dabei auf einem drehangetriebenen Gaspolster liegen. Bevorzugt liegen die planetenartig angeordneten Substrathalter auf Einzelsubstratträgern, welche drehangetrieben im Substrathalter 4 angeordnet sind.

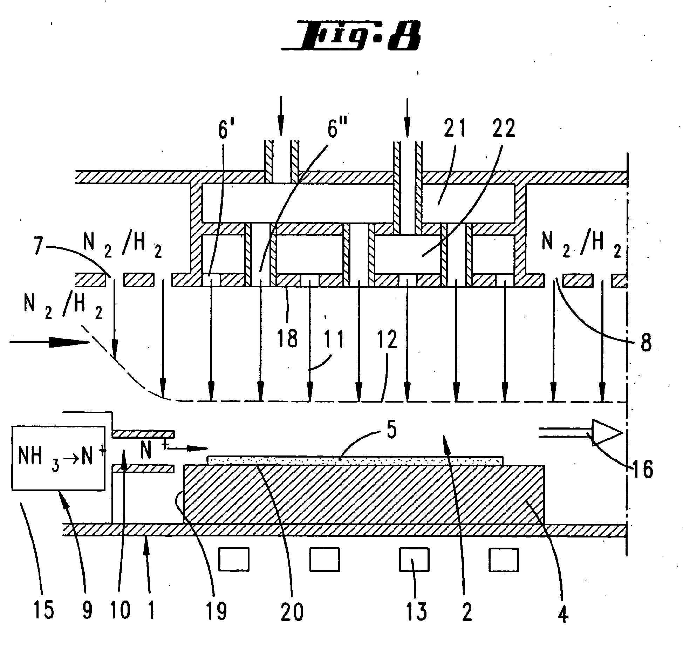

Bei dem in Fig. 8 dargestellten Ausführungsbeispiel werden zwei verschiedene Alkyle in die Prozesskammer eingeleitet. Dabei wird jedes der beiden Alkyle in eine gesonderte Kammer 21, 22 des Gaseinlassorganes 3 geleitet. Jede der beiden Kammern 21, 22 ist mit gesonderten Gaseintrittsöffnungen 6', 6" versehen, die in die Prozesskammer münden. Hierdurch werden Vorreaktionen zwischen den einzelne Metallalkylen vermieden. Betreffend die Einzelheiten derartiger Kammern wird auf die US 5,871,586 verwiesen.

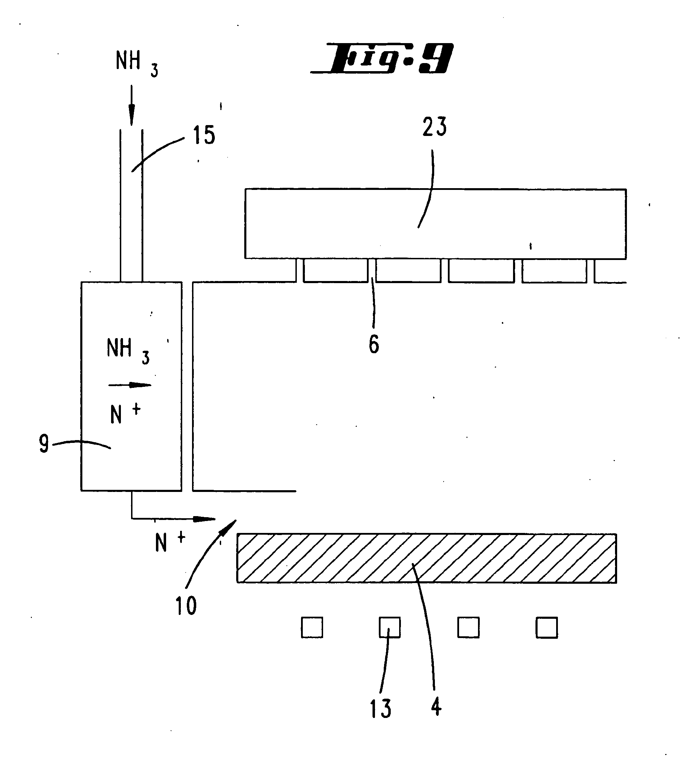

Bei dem in der Fig. 9 dargestellten weiteren Ausführungsbeispiel wird das oder die Alkyle in einer besonderen Vorkonditioniereinrichtung 23 vorkonditioniert. Auch hier werden die Hydride in einer Vorkonditionierungsvorrichtung 9 vorkonditioniert. Hier erfolgt die Zuleitung der Hydride 15 von oben. Die Vorkonditionierungseinrichtung 9 befindet sich etwa auf Höhe der Prozesskammer. Die Injektion der Radikale erfolgt aber auch hier durch einen Austrittskanal 10, der unmittelbar am Rand des Substrathalters 4 angeordnet ist. Die Injektion der Radikale erfolgt unmittelbar in die Diffusionsgrenzschicht.

Diese weitere Vorkonditionierungseinrichtung 23 für die Alkyle befindet sich im Bereich des "shower heads" unmittelbar im Bereich der Decke der Prozesskanuner. Durch die Gaseintrittsöffnungen 6 tritt das vorkonditionierte Prozessgas zusammen mit einem Trägergas in der zuvor beschriebenen Weise in die Prozesskammer ein. Bei der Vorkonditionierungsvorrichtung 23 kann es sich um eine Kühleinrichtung handeln. Die Kühlung kann durch eine Kühlflüssigkeit oder in anderer Weise erfolgen, bspw. durch Gasströme oder durch Wärmeableitung. Die Wärme kann dabei über einen einstellbaren Gasspalt abgeleitet werden.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlägen in Ansprüche vorliegender Anmeldung mit aufzunehmen.

## Patentansprüche

1. Verfahren zum Abscheiden mindestens einer Schicht, insbesondere Halbleiterschicht auf mindestens einem in einer Prozesskammer (2) eines Reaktors (1) von einem Substrathalter (4) getragenen Substrat (5), wobei die Schicht aus mindestens zwei in einem festen stöchiometrischen Verhältnis stehenden Materialkomponenten besteht, die jeweils in Form eines ersten und eines zweiten Reaktionsgases in den Reaktor (1) eingeleitet werden, wo die Reaktionsgase zufolge einer Energiezufuhr zerlegt werden und ein Teil der Zerlegungsprodukte die Schicht bildet, wobei das Angebot des ersten, eine niedrige thermische Aktivierungsenergie aufweisenden Reaktionsgases die Wachstumsrate der Schicht bestimmt und das zweite, eine hohe thermische Aktivierungsenergie aufweisende Reaktionsgas im Überschuss angeboten und insbesondere durch unabhängige Energiezufuhr vorkonditioniert wird, wobei das erste Reaktionsgas durch eine Vielzahl von Öffnungen (6), die verteilt auf einer dem Substrathalter (4) gegenüberliegenden Fläche (18) eines Gaseinlassorganes (3) angeordnet sind, in Richtung (11) auf den Substrathalter (4) strömt, **dadurch gekennzeichnet, dass** das zweite Reaktionsgas vor dem Eintritt in die Prozesskammer (2) vorkonditioniert wird und am Rande (19) des Substrathalters (4) unmittelbar oberhalb desselben in die Prozesskammer (2) eintritt und parallel zur Substrathalteroberfläche (20) strömt.

2. Verfahren nach Anspruch 1, **dadurch gekennzeichnet, dass** das zweite Reaktionsgas ein Hydrid, insbesondere NH₃, PH₃ oder AsH₃ ist.

3. Verfahren nach einem der vorhergehenden Ansprüche, **dadurch gekennzeichnet, dass** das zweite Reaktionsgas thermisch und/oder katalytisch vorkonditioniert wird.

4. Verfahren nach einem der Ansprüche 1 oder 2, **dadurch gekennzeichnet, dass** das zweite Reaktionsgas mittels eines Plasmas vorkonditioniert wird.

5. Verfahren nach einem der vorhergehenden Ansprüche, **dadurch gekennzeichnet, dass** der Massenfluss der durch die Vorkonditionierung entstandenen Radikale des zweiten Reaktionsgases in die Prozesskammer nur geringfügig größer ist als der Massenfluss des ersten Reaktionsgases in die Prozesskammer (2).

6. Verfahren nach einem der vorhergehenden Ansprüche, **dadurch gekennzeichnet, dass** das Verhältnis der durch die Vorkonditionierung entstandenen Radikale zum ersten Prozessgas über die gesamte Länge der Prozesskammer (2) bzw. über den gesamten Radius in der Prozesskammer (2) unmittelbar auf der Substratoberfläche > 1 ist.

7. Verfahren nach einem der vorhergehenden Ansprüche, **gekennzeichnet durch** ein derart hohes Angebot der Zerlegungsprodukte des Hydrides, dass Wachstumsraten der abzuscheidenden Schicht bei hoher Schichtqualität von mehr als 5µm/h erzielbar sind.

8. Verfahren nach einem der vorhergehenden Ansprüche, **gekennzeichnet durch** erzielbare EPD (etch pit density) von weniger als 10¹¹ cm⁻², weniger als 10⁹ cm⁻², weniger als 10⁸ cm⁻².

9. Verfahren nach einem der vorhergehenden Ansprüche, **gekennzeichnet durch** Prozesstemperaturen zwischen 400 und 1600°C vorzugsweise im Bereich zwischen 500°C und 1200°C.

10. Verfahren nach einem der vorhergehenden Ansprüche, **dadurch gekennzeichnet, dass** das vorkonditionierte zweite Prozessgas innerhalb einer Strömungs-/Diffusionsgrenzschicht (12) in die Prozesskammer diffundiert.

11. Verfahren nach Anspruch 10, **dadurch gekennzeichnet, dass** die Strömungs-/Diffusionsgrenzschicht unterhalb der Mitte der Höhe der Prozesskammer (2) liegt.

12. Verfahren nach einem der Ansprüche 10 oder 11, **dadurch gekennzeichnet, dass** die Strömungs-Diffusionsgrenzschicht (12) durch die Öffnungen (6) des Gaseinlassorganes (3) in Hauptstromrichtung (11) vor- und/oder nachgeordnete Öffnungen (7, 8) strömendes Trägergas konditioniert wird.

13. Verfahren nach einem der vorhergehenden Ansprüche, **dadurch gekennzeichnet, dass** das erste Reaktionsgas TMG, TMI, TEG, TMAL, DcpMg, DEZn oder ein anderes Metallalkyl ist.

14. Verfahren nach einem der vorhergehenden Ansprüche, **dadurch gekennzeichnet, dass** der Strom des zusammen mit dem ersten Reaktionsgas durch das Gaseinlassorgan (3) in die Prozesskammer (2) eingeleitete Trägergas so eingestellt ist, dass die Strömung des vorkonditionierten zweiten Reaktionsgases flach auf die Substratoberfläche (20) gedrückt wird.

15. Vorrichtung insbesondere zur Durchführung des Verfahrens nach einem oder mehreren der vorhergehenden Ansprüche mit einer in einem Reaktor (1) angeordneten Prozesskammer (2), welche Prozesskammer (2) einen Substrathalter (4) für mindestens ein Substrat (5) aufweist, mit einer Heizvorrichtung (13), um den Substrathalter (4) auf eine Prozesstemperatur aufzuheizen, mit einem dem Substrathalter (4) gegenüberliegenden Gaseinlassorgan (3) zum Einleiten eines ersten Reaktionsgases in die Prozesskammer, wobei das Gaseinlassorgan (3) eine Vielzahl von Öffnungen (6) zum Austritt des ersten Reaktionsgases aufweist, welche Öffnungen (6) verteilt auf der dem Substrathalter (4) gegenüberliegenden Fläche (18) des Gaseinlassorganes (3) angeordnet sind, und mit einer Vorrichtung (9) zur Vorkonditionierung eines zweiten, in die Prozesskammer (2) einzuleitenden Reaktionsgases, **dadurch gekennzeichnet, dass** die Vorrichtung (9) zur Vorkonditionierung derart am Rande (19) des Substrathalters angeordnet ist, dass das zweite Reaktionsgas unmittelbar oberhalb des Substrathalters (4) und quer zur Einströmungsrichtung (11) des ersten Reaktionsgases parallel zur Substrathalteroberfläche (20) strömt.

16. Vorrichtung nach Anspruch 15, **dadurch gekennzeichnet, dass** der Substrathalter ringförmig gestaltet ist und sich die Vorkonditionierungsvorrichtung (9) im Ringinnenraum befindet.

17. Vorrichtung nach Ansprüchen 15 und 16, **dadurch gekennzeichnet, dass** der Substrathalter (4) trapezförmig ausgebildet ist und sich die Vorkonditionierungseinrichtung (9) vor der Schmalseite des Trapezes befindet.

18. Vorrichtung nach den Ansprüchen 15 bis 17, **dadurch gekennzeichnet, dass** die Querschnittsfläche der Prozesskammer oberhalb des Substrathalters (4) in Gasabströmrichtung (16) konstant ist.

19. Vorrichtung nach den Ansprüchen 15 bis 18, **dadurch gekennzeichnet, dass** das Gaseinlassorgan duschkopfartig und insbesondere als closed capped showerhead ausgebildet ist, insbesondere mit einer Prozesskammerhöhe zwischen 10mm und 75 mm.

20. Vorrichtung nach den Ansprüchen 15 bis 19, **dadurch gekennzeichnet, dass** den Öffnungen (6) des Gaseinlassorganes (3) in Hauptgasstromrichtung (11) sowohl vor- als auch nachgeordnete Öffnungen (7, 8) benachbart sind, durch welche zur Konditionierung einer Diffusions-/Strömungsgrenzschicht Trägergas in Richtung quer zur Hauptgasstromrichtung (16) in die Prozesskammer (2) eingeleitet wird.

21. Vorrichtung nach den Ansprüchen 15 bis 20, **dadurch gekennzeichnet, dass** die Vorkonditionierungsvorrichtung (9) einen Plasmagenerator aufweist.

22. Vorrichtung nach den Ansprüchen 15 bis 20, **dadurch gekennzeichnet, dass** die Vorkonditionierungsvorrichtung (9) eine Heizung, insbesondere eine Heißdrahtvorrichtung aufweist.

23. Vorrichtung nach den Ansprüchen 15 bis 22, **dadurch gekennzeichnet, dass** die Prozesskammerhöhe > 75 mm ist und die Rotationsgeschwindigkeit des drehangetriebenen Substrathalters (4) > ist als 100 bis 1000 rpm.

24. Vorrichtung nach den Ansprüchen 15 bis 23, **dadurch gekennzeichnet, dass** die Radikaleninjektion am äußeren Rand eines ringförmigen Substrathalters. (4) erfolgt.

25. Vorrichtung nach den Ansprüchen 15 bis 24, **dadurch gekennzeichnet, dass** die Zuleitung der Metallalkyle durch ein zwei Kammern (21, 22) aufweisendes Gaseinlasssystem (3) durch voneinander getrennte Gaseintrittsöffnungen (6', 6") erfolgt.

26. Vorrichtung nach den Ansprüchen 15 bis 25, **gekennzeichnet durch** eine dem Gaseinlassorgan (3) zugeordnete Vorkonditionierungseinrichtung (23) für die Metallalkyle.

## Claims

1. Process for depositing at least one layer, in particular semiconductor layer, on at least one substrate (5) carried by a substrate holder (4) in a process chamber (2) of a reactor (1), the layer consisting of at least two material components which are in a fixed stochiometric ratio and are respectively introduced in the form of a first reaction gas and a second reaction gas into the reactor (1), where the reaction gases are decomposed as a result of a supply of energy, and some of the decomposition products form the layer, the supply of the first reaction gas, which has a low thermal activation energy, determining the growth rate of the layer, and the second reaction gas, which has a high thermal activation energy, being supplied in excess and in particular being preconditioned by independent supply of energy, the first reaction gas flowing in the direction (11) of the substrate holder (4) through a multiplicity of openings (6) which are disposed distributed over a surface (18) of a gas inlet member (3) lying opposite the substrate holder (4), **characterized in that** the second reaction gas is preconditioned before it enters the process chamber (2) and enters the process chamber (2) at the edge (19) of the substrate holder (4), immediately above the latter, and flows parallel to the substrate holder surface (20).

2. Process according to claim 1, **characterized in that** the second reaction gas is a hydride, in particular NH₃, PH₃ or AsH₃.

3. Process according to one of the preceding claims, **characterized in that** the second reaction gas is preconditioned thermally and/ or catalytically.

4. Process according to one of the claims 1 or 2, **characterized in that** the second reaction gas is preconditioned by means of a plasma.

5. Process according to one of the preceding claims, **characterized in that** the mass flow of the radicals of the second reaction gas formed as a result of the preconditioning into the process chamber is only slightly greater than the mass flow of the first reaction gas into the process chamber (2).

6. Process according to one of the preceding claims, **characterized in that** the ratio of the radicals formed as a result of the preconditioning to the first process gas directly on the substrate surface is > 1 over the entire length of the process chamber (2) or over the entire radius in the process chamber (2).

7. Process according to one of the preceding claims, **characterized by** such a high supply of the decomposition products of the hydride that growth rates of the layer to be deposited of more than 5µm/h can be achieved with a high layer quality.

8. Process according to one of the preceding claims, **characterized by** EPDs (etch pit densities) of less than 10¹¹cm⁻², less than 10⁹cm⁻², less than 10⁸cm⁻² being achievable.

9. Process according to one of the preceding claims, **characterized by** process temperatures of between 400 and 1600°C, preferably in the range between 500°C and 1200°C.

10. Process according to one of the preceding claims, **characterized in that** the preconditioned second process gas diffuses into the process chamber within a flow/ diffusion boundary layer (12).

11. Process according to claim 10, **characterized in that** the flow/ diffusion boundary layer lies below the center of the height of the process chamber (2).

12. Process according to one of claims 10 or 11, **characterized in that** the flow/ diffusion boundary layer (12) is conditioned by carrier gas flowing through openings (7, 8) disposed upstream and/or downstream of the openings (6) in the gas inlet member (3), as seen in the main direction of flow (11).

13. Process according to one of the preceding claims, **characterized in that** the first reaction gas is TMG, TMI, TEG, TMAL, DcpMg, DEZn or another metal alkyl.

14. Process according to one of the preceding claims, **characterized in that** the flow of the carrier gas which is introduced into the process chamber (2) through the gas inlet member (3) together with the first reaction gas is set in such a way that the flow of the preconditioned second reaction gas is pressed flat onto the substrate surface (20).

15. Apparatus in particular for carrying out the process according to one or more of the preceding claims, having a process chamber (2) disposed in a reactor (1), which process chamber (2) has a substrate holder (4) for at least one substrate (5), having a heating apparatus (13) for heating the substrate holder (4) to a process temperature, having a gas inlet member (3), which lies opposite the substrate holder (4), for introducing a first reaction gas into the process chamber, the gas inlet member (3) having a multiplicity of openings (6) for discharging the first reaction gas, which openings (6) are disposed distributed over the surface (18) of the gas inlet member (3) lying opposite the substrate holder (4), and having an apparatus (9) for preconditioning a second reaction gas which is to be introduced into the process chamber (2), **characterized in that** the preconditioning apparatus (9) is disposed at the edge (19) of the substrate holder in such a manner that the second reaction gas flows parallel to the substrate holder surface (20) immediately above the substrate holder (4) and transversely with respect to the direction (11) in which the first process gas flows in.

16. Apparatus according to claim 15, **characterized in that** the substrate holder is configured in the shape of a ring, and the preconditioning apparatus (9) is located in the space inside the ring.

17. Apparatus according to claims 15 and 16, **characterized in that** the substrate holder (4) is in the shape of a trapezium, and the preconditioning device (9) is situated upstream of the narrow side of the trapezium.

18. Apparatus according to claims 15 to 17, **characterized in that** the cross-sectional area of the process chamber above the substrate holder (4) is constant in the direction (16) in which the gas flows out.

19. Apparatus according to claims 15 to 18, **characterized in that** the gas inlet member is of showerhead form, and in particular is configured as a closed capped showerhead, in particular with a process chamber height of between 10 mm and 75 mm.

20. Apparatus according to claims 15 to 19, **characterized in that** openings (7, 8) are adjacent to the openings (6) in the gas inlet member (3) both upstream and downstream of them in the main direction of gas flow (11), through which upstream and downstream openings (7, 8) carrier gas is introduced into the process chamber (2) in a direction which is transverse to the main direction of gas flow (16), for the purpose of conditioning a diffusion/flow boundary layer.

21. Apparatus according to claims 15 to 20, **characterized in that** the preconditioning apparatus (9) includes a plasma generator.

22. Apparatus according to claims 15 to 20, **characterized in that** the preconditioning apparatus (9) has a heater, in particular a hot-wire apparatus.

23. Apparatus according to claims 15 to 22, **characterized in that** the process chamber height is > 75 mm and the rotational speed of the substrate holder (4) which is driven in rotation, is > 100 up to 1000 rpm.

24. Apparatus according to claims 15 to 23, **characterized in that** the injection of radicals takes place at the outer edge of a ring-shaped substrate holder (4).

25. Apparatus according to claims 15 to 24, **characterized in that** the metal alkyls are supplied through separate gas entry openings (6', 6") via a gas inlet system (3) which includes two chambers (21, 22).

26. Apparatus according to claims 15 to 25, **characterized by** a preconditioning device (23), which is associated with the gas inlet member (3) for the metal alkyls.

## Revendications

1. Procédé de dépôt d'au moins une couche, notamment d'une couche de semi-conducteur sur au moins un substrat (5) supporté par un porte-substrat (4) dans une chambre de réaction (2) d'un réacteur (1), la couche étant constituée d'au moins deux composants dans un rapport stoechiométrique fixe, lesquels sont chacun introduits sous la forme d'un premier gaz de réaction et d'un second gaz de réaction dans le réacteur (1) dans lequel les gaz de réaction sont décomposés par apport d'énergie et une partie du produit de la décomposition forme la couche, l'apport du premier gaz de réaction présentant une énergie d'activation thermique faible déterminant la vitesse de croissance de la couche et le second gaz de réaction qui présente une énergie d'activation thermique élevée étant apporté en accès et étant préconditionné notamment par un apport d'énergie indépendant, le premier gaz de réaction s'écoulant en direction (11) du porte-substrat (4) par un grand nombre d'ouvertures (6) qui sont disposées de façon répartie sur une surface (18), opposée au porte-substrat (4), d'un organe d'admission de gaz (3), **caractérisé en ce que** le second gaz de réaction est préconditionné avant d'entrer dans la chambre de réaction (2) et entre dans la chambre de réaction (2) au niveau du bord (19) du porte-substrat (4) directement au-dessus de celui-ci et s'écoule parallèlement à la surface (20) du porte-substrat.

2. Procédé selon la revendication 1, **caractérisé en ce que** le deuxième gaz de réaction est un hydrure, notamment du NH₃, PH₃ ou ASH3.

3. Procédé selon l'une des revendications précédentes, **caractérisé en ce que** le second gaz de réaction est préconditionné du point de vue thermique et/ou catalytique.

4. Procédé selon l'une des revendications 1 ou 2, **caractérisé en ce que** le second gaz de réaction est préconditionné au moyen d'un plasma.

5. Procédé selon l'une des revendications précédentes, **caractérisé en ce que** le flux massique des radicaux, généré par le préconditionnement, du second gaz de réaction dans la chambre de réaction n'est que légèrement supérieur au flux massique du premier gaz de réaction dans la chambre de réaction (2).

6. Procédé selon l'une des revendications précédentes, **caractérisé en ce que** le rapport des radicaux générés par le préconditionnement sur le premier gaz de réaction est supérieur à un sur toute la longueur de la chambre de réaction (2) ou sur toute le rayon dans la chambre de réaction (2) directement sur la surface du substrat.

7. Procédé selon l'une des revendications précédentes, **caractérisé en ce que** les produits de la décomposition de l'hydrure sont apportés dans une quantité telle que les vitesses de croissance de la couche à déposer pour une qualité de couche élevée peut atteindre plus de 5 µm/h.

8. Procédé selon l'une des revendications précédentes, **caractérisé par** une densité de piqûres de corrosion EDP (etch pit density) atteignable de moins de 10¹¹ cm⁻², de moins de 10⁹ cm⁻², de moins de 10⁸ cm⁻².

9. Procédé selon l'une des revendications précédentes, **caractérisé par** des températures de réaction comprises entre 400 et 1600°C, de préférence dans la plage allant de 500°C à 1200°C.

10. Procédé selon l'une des revendications précédentes, **caractérisé en ce que** le deuxième gaz de réaction préconditionné diffuse dans la chambre de réaction à l'intérieur d'une couche limite de diffusion/d'écoulement (12).

11. Procédé selon la revendication 10, **caractérisé en ce que** la couche limite de diffusion/d'écoulement est située au-dessous du milieu de la hauteur de la chambre de réaction (2).

12. Procédé selon la revendication 10 ou 11, **caractérisé en ce que** la couche limite de diffusion/d'écoulement (12) est conditionné par du gaz porteur s'écoulant par des ouvertures (7, 8) ménagées en amont et/ou en aval des ouvertures (6) de l'organe d'admission de gaz (3) par référence à la direction d'écoulement principale (11).

13. Procédé selon l'une des revendications précédentes, **caractérisé en ce que** le premier gaz de réaction est du TMG, TMI, TEG, TMAL, DcpMg, DEZn ou un autre alkyle métallique.

14. Procédé selon l'une des revendications précédentes, **caractérisé en ce que** l'écoulement du gaz porteur introduit conjointement avec le premier gaz de réaction dans la chambre de réaction (2) par l'organe d'admission de gaz est réglé de telle façon que l'écoulement du deuxième gaz de réaction préconditionné exerce une pression sur la couche (20) du substrat.

15. Dispositif destiné notamment à mettre en oeuvre le procédé selon l'une ou plusieurs des revendications précédentes, ledit dispositif comportant une chambre de réaction (2) qui est disposée dans un réacteur (2), laquelle chambre de réaction (2) possède un porte-substrat (4) destiné à au moins un substrat (5), un dispositif de chauffage (13) pour chauffer le porte-substrat (4) à une température de réaction, un organe d'admission de gaz (3) opposé au porte-substrat (4) et destiné à introduire un premier gaz de réaction dans chambre de réaction, l'organe d'admission de gaz (3) présentant un grand nombre d'ouvertures (6) pour faire sortir le premier gaz de réaction, lesquelles ouvertures (6) sont disposées de façon répartie sur la surface (18), opposée au porte-substrat (4), de l'organe d'admission de gaz (3), et un dispositif (9) destiné à préconditionner un deuxième gaz de réaction à introduire dans la chambre de réaction (2), **caractérisé en ce que** le dispositif (9) destiné au préconditionnement est disposé au niveau du bord (19) du porte-substrat de telle façon que le second gaz de réaction s'écoule directement au-dessus du porte-substrat (4) et transversalement à la direction d'injection (11) du premier gaz de réaction parallèlement à la surface (20) du porte-substrat.

16. Dispositif selon la revendication 15, **caractérisé en ce que** le porte-substrat a une forme annulaire et le dispositif de préconditionnement (9) se trouve dans l'espace intérieur annulaire.

17. Dispositif selon les revendications 15 et 16, **caractérisé en ce que** le porte-substrat (4) a une forme trapézoïdale et le dispositif de préconditionnement (9) se trouve en avant du petit côté du trapèze.

18. Dispositif selon les revendications 15 à 17, **caractérisé en ce que** la section de la chambre de réaction au-dessus du porte-substrat (4) en direction (16) de la sortie de gaz est constante.

19. Dispositif selon les revendications 15 à 18, **caractérisé en ce que** l'organe d'admission de gaz est conformé en pomme d'arrosage et notamment en closed capped showerhead', notamment avec une hauteur de chambre de réaction comprise entre 10 mm 75 mm.

20. Dispositif selon les revendications 15 à 19, **caractérisé en ce que** les ouvertures (7, 8), ménagées aussi bien en amont qu'en aval par référence à la direction d'écoulement de gaz principale (11), sont adjacentes aux ouvertures (6) de l'organe d'admission de gaz (3), lesquelles ouvertures (7, 8) permettent d'introduire du gaz porteur dans la chambre de réaction (2) dans une direction transversale à la direction d'écoulement de gaz principale (16) afin de conditionner une couche limite de diffusion/d'écoulement.

21. Dispositif selon les revendications 15 à 20, **caractérisé en ce que** le dispositif de préconditionnement (9) possède un générateur de plasma.

22. Dispositif selon les revendications 15 à 20, **caractérisé en ce que** le dispositif de préconditionnement (9) possède un dispositif de chauffage, notamment un dispositif de chauffage filaire.

23. Dispositif selon les revendications 15 à 22, **caractérisé en ce que** la hauteur de la chambre de réaction est supérieure à 75 mm et les vitesses de rotation du porte-substrat (4) entraîné en rotation vont de 100 à 1 000 tr/m.

24. Dispositif selon les revendications 15 à 23, **caractérisé en ce que** l'injection des radicaux est effectuée au niveau du bord extérieur d'un porte-substrat annulaire (4).

25. Dispositif selon les revendications 15 à 24, **caractérisé en ce que** l'amenée des alkyles métalliques est effectuée par un système d'admission de gaz (3), comportant deux chambres (21, 22), par le biais d'ouvertures d'entrée de gaz (6', 6 " ) séparées l'une de l'autre.

26. Dispositif selon les revendications 15 à 25, **caractérisé par** un dispositif de préconditionnement (23) associé à l'organe d'admission de gaz (3) et destiné aux alkyles métalliques.
